# EUROPÄISCHE PATENTSCHRIFT

(11) **EP 3 536 436 B1**
(45) Veröffentlichungstag und Bekanntmachung des Hinweises auf die Patenterteilung: **15.07.2020**
(21) Anmeldenummer: 18160851.4
(22) Anmeldetag: 09.03.2018
(51) Int. Cl.: B23K 20/10, H01R 43/02, H01L 21/607, B23K 101/32

(54) **VORRICHTUNG UND VERFAHREN ZUM VERBINDEN VON WERKSTÜCKEN**
DEVICE AND METHOD FOR CONNECTING WORKPIECES
DISPOSITIF ET PROCÉDÉ DE RACCORDEMENT DE PIÈCES À USINER

(43) Veröffentlichungstag der Anmeldung: 11.09.2019
(73) Patentinhaber: Telsonic Holding AG, 9552 Bronschhofen (CH)
(72) Erfinder: Solenthaler, Peter, 9543 St. Margarethen (CH); Büttiker, Albert, 9607 Mosnang (CH); Lang, Georg, 97855 Triefenstein (DE)
(74) Vertreter: Hepp Wenger Ryffel AG

(56) Entgegenhaltungen:
- WO-A1-2005/021203
- WO-A2-2009/060080
- DE-A1-102006 021 651
- DE-B3-102007 026 707

## Beschreibung

Die Erfindung betrifft eine Vorrichtung und ein Verfahren zum Verbinden von Werkstücken mittels Schwingungen gemäss dem Oberbegriff der unabhängigen Patentansprüche.

Es ist bekannt, insbesondere metallische Werkstücke wie Litzen und/oder Terminals, durch Einleiten von Schwingungen, insbesondere Ultraschallschwingungen zu verbinden. Dabei wird durch eine Sonotrode und einen Amboss sowie durch Seitenbegrenzer ein Arbeitsraum gebildet, in den die Werkstücke eingelegt und gegebenenfalls komprimiert werden. Zum Verbinden werden Schwingungen erzeugt und in die Werkstücke eingeleitet. Die Schwingungsrichtung verläuft im Wesentlichen parallel zu einer Arbeitsfläche der Sonotrode. Dabei ist es bekannt, Schwingungen mit einer torsional oder mit einer longitudinal angeregten Sonotrode zu erzeugen. Eine entsprechende Vorrichtung ist beispielsweise in WO 2012/069413 A1 gezeigt.

Vor allem beim Verschweissen von Litzen mit grossen Querschnitten muss eine erhebliche Energie in die Werkstücke eingebracht werden. Dabei besteht das Problem, dass Schwingungen in Komponenten der Anlage, beispielsweise die Seitenbegrenzer, übertragen werden und dort zu Erwärmungen führen. Entsprechend ist der Wirkungsgrad von solchen Vorrichtungen oft nicht optimal und es kann erforderlich sein, derart erwärmte Anlagenteile zu kühlen. Ausserdem besteht insbesondere beim Verschweissen von Litzen aus Aluminium das Problem des Anhaftens an statischen Begrenzungsflächen des Arbeitsraums.

Aus WO 2009/060080 A2 ist ein Verfahren zum Reduzieren des Anlegierens von Aluminium an Begrenzungsflächen eines Arbeitsraums bekannt, bei dem Arbeitsflächen aus polykristallinem Diamant verwendet werden. Diese Lösung ist aufwendig in ihrer Herstellung.

Die Aufgabe der Erfindung besteht darin, die Nachteile des Bekannten zu vermeiden, insbesondere also eine Vorrichtung und ein Verfahren zu schaffen, welche eine möglichst effiziente Verwendung der eingesetzten Schwingungsenergie ermöglichen und welche ein Anhaften von Teilen an Begrenzungsflächen des Arbeitsraums reduzieren oder verhindern.

Erfindungsgemäss werden diese Aufgaben mit einer Vorrichtung und einem Verfahren mit den Merkmalen des kennzeichnenden Teils der unabhängigen Patentansprüche gelöst.

Die erfindungsgemässe Vorrichtung dient zum Verbinden von Werkstücken mittels Schwingungen. Bevorzugt werden Ultraschallschwingungen verwendet. Zu verbindende Werkstücke sind typischerweise metallische Werkstücke und elektrische Leiter. Beispielsweise können Litzen mit Litzen oder Litzen mit Terminals verbunden werden.

Die Vorrichtung umfasst eine Sonotrode, einen Amboss und Seitenbegrenzer.

Die Sonotrode weist einen Sonotrodenkopf auf, welcher von wenigstens einem Schwingungserzeuger in Schwingungen in einer Schwingungsrichtung versetzbar ist. Der Sonotrodenkopf weist eine Arbeitsfläche auf, welche im Wesentlichen parallel zur Schwingungsrichtung verläuft. Typischerweise ist die Arbeitsfläche im Bereich eines Schwingungsmaximums der Sonotrode angeordnet, so dass sie mit der maximal möglichen Amplitude schwingt. Die Sonotrode kann sowohl longitudinal oder torsional angetrieben sein. In beiden Fällen befindet sich die Arbeitsfläche im Bereich des Umfanges der Sonotrode. Bei longitudinaler Anregung schwingt die Arbeitsfläche in Richtung der Längsachse der Sonotrode. Bei torsionaler Anregung schwingt die Arbeitsfläche in Umfangsrichtung.

Der Amboss weist eine der Arbeitsfläche gegenüberliegende und von dieser beabstandete Ambossfläche auf. Zwischen der Ambossfläche und der Arbeitsfläche wird so ein Arbeitsraum gebildet.

Die Seitenbegrenzer weisen seitliche Begrenzungsflächen auf. Die Begrenzungsflächen erstrecken sich zwischen der Ambossfläche und der Arbeitsfläche und begrenzen den Arbeitsraum seitlich.

Erfindungsgemäss ist wenigstens einer der Seitenbegrenzer so geformt, dimensioniert und gelagert, dass die Begrenzungsfläche bei Kontakt mit wenigstens einem der in den Arbeitsraum eingesetzten und von der Arbeitsfläche mit Schwingungen beaufschlagten Werkstücke in Schwingungen in einer Richtung etwa parallel zur Arbeitsfläche versetzt werden kann. Durch diese Abstimmung des Seitenbegrenzers schwingt dieser mit dem oder den mit dem Seitenbegrenzer in Kontakt stehenden Werkstücken mit. Eine Reibung zwischen Seitenbegrenzungsfläche und Werkstück wird damit reduziert oder weitgehend vermieden. Dadurch entsteht weniger Abwärme und das Problem des Anhaftens insbesondere von Aluminiumlitzen wird reduziert.

Dabei ist der wenigstens eine Seitenbegrenzer vorteilhaft auf die Anregungsfrequenz des Schwingungserzeugers abgestimmt, so dass er in einem Schwingungsmodus mit einer Resonanzfrequenz schwingt, die benachbart zur Anregungsfrequenz liegt. Dabei sollte die Resonanzfrequenz in Theorie möglichst mit der Anregungsfrequenz übereinstimmen und in der Praxis leicht oberhalb der Anregungsfrequenz liegen. Bei einer Anregungsfrequenz im Bereich von 10 bis 40 kHz liegt die Resonanzfrequenz des Seitenbegrenzers typischerweise in einem Bereich von 200 bis 2000 kHz oberhalb der Anregungsfrequenz des Schwingungserzeugers. Dabei ist zu beachten, dass bei allen bestimmungsgemässen Betriebsbedingungen die Resonanzfrequenz des Seitenbegrenzers oberhalb der Anregungsfrequenz bleibt. Wenn die Anregungsfrequenz des Schwingungserzeugers über die Resonanzfrequenz des Seitenbegrenzers ansteigt, könnte ein gegenteiliger Effekt entstehen und der Seitenbregenzer könnte gegenläufig schwingen, was zu erhöhter Reibung führen könnte.

Körper wie beispielsweise der Seitenbegrenzer können in verschiedenen Schwingungsmodi in Resonanz schwingen. Bekannt sind beispielsweise Längsschwingungen, Biegeschwingungen oder Torsionsschwingungen. Bevorzugt ist der Seitenbegrenzer so abgestimmt, dass er in einer Beigeschwingung mit einer der Anregungsfrequenz des Schwingungserzeugers angepassten Resonanzfrequenz schwingt. Die Seitenbegrenzungsflächen führen dann als Teil einer Biegeschwingung eine Bewegung in einer Richtung parallel zur Arbeitsfläche der Sonotrode aus.

Dabei ist es besonders bevorzugt, wenn der Seitenbegrenzer in wenigstens einem Schwingungsknoten gelagert ist. Dadurch wird der Wirkungsgrad zusätzlich vergrössert und die Abwärme reduziert, bei einer besonders einfachen Konstruktion. Es sind aber auch andere schwingungsentkoppelte Lagerungen, beispielsweise federnde Lagerungen, denkbar.

Um eine gezielte Kopplung der Schwingungen von den Werktücken an den Seitenbegrenzer zu bewerkstelligen, ist der Seitenbegrenzer bevorzugt gegen den Arbeitsraum verschiebbar gelagert, so dass er mit einer Anpresskraft gegen das Werkstück anpressbar ist. Gemäss einer weiteren bevorzugten Ausführungsform ist der Seitenbegrenzer auf einer der Begrenzungsfläche gegenüberliegenden Seite mit einer Ausgleichsmasse versehen. Insbesondere weist in einer Richtung parallel zur Arbeitsfläche gesehen der Seitenbegrenzer an der gegenüberliegenden Seite eine Breite auf, die grösser ist als die Breite der den Arbeitsraum begrenzenden Begrenzungsfläche. Mit einer solchen Ausgleichsfläche kann das System schwingungsmässig optimiert werden. Insbesondere kann die maximale Auslenkung der Begrenzungsfläche in Schwingungsrichtung (das heisst die mögliche Amplitude) vergrössert werden.

Bevorzugt kann die Vorrichtung zusätzlich mit wenigstens einem Klemmelement versehen sein. Das Klemmelement dient dazu, wenigstens eines der Werkstücke gegen den Amboss zu klemmen. Typischerweise wird mit einem solchen Klemmelement ein Terminal, auf den eine Litze geschweisst werden soll, gegen den Amboss gedrückt. Während es im Stand der Technik bereits bekannt ist, ein Terminal mittels eines Seitenbegrenzers gegen des Amboss zu drücken, ist gemäss der vorliegenden bevorzugten Ausführungsform ein separates Klemmelement vorgesehen, das insbesondere schwingungsentkoppelt vom Seitenbegrenzer ist. Weiter bevorzugt ist das Klemmelement bezogen auf den Arbeitsraum um einen Abstand gegenüber der Begrenzungsfläche des Seitenbegrenzers zurückversetzt. Auf diese Weise wird verhindert, dass Schwingungen von dem oder den Werkstücken auf das Klemmelement übertragen werden.

Ausserdem kann zwischen Sonotrode und/oder Klemmelement einerseits und dem Seitenbegrenzer andererseits ein Spalt gebildet sein. Störende Übertragungen von Schwingungen direkt von der Sonotrode auf den Seitenbegrenzer oder Schwingungsübertragungen vom Seitenbegrenzer auf das Klemmelement werden dadurch verhindert.

Das Klemmelement kann ausserdem eine Klemmfläche aufweisen, die näher zur Ambossfläche angeordnet ist als eine dem Amboss zugewandte Unterseite des Seitenbegrenzers. Auch auf diese Weise wird die Einkopplung von Schwingungen vom Seitenbegrenzer auf weitere Bauteile, insbesondere auf den Amboss, verhindert. Auch damit lässt sich der Wirkungsgrad erhöhen.

Erfindungsgemäss weist die Vorrichtung zwei Seitenbegrenzer auf. In diesem Fall ist die Vorrichtung insbesondere bezogen auf eine Mittenebene durch den Arbeitsraum symmetrisch ausgebildet, so dass sich auf beiden Seiten des Arbeitsraums im Wesentlichen identisch ausgebildete zweite Begrenzer befinden. Ebenfalls symmetrisch sind in diesem Fall bevorzugt auf beiden Seiten Klemmelemente angeordnet. Es sind aber auch asymmetrische Anordnungen denkbar, oder Anordnungen, bei denen die Seitenbegrenzer bezogen auf die Mittenebene verschoben sind.

Gemäss einer alternativen bevorzugten Ausführungsform ist ein Seitenbegrenzer als Ambossplatte ausgebildet. In diesem Fall ist die Ambossplatte in an sich bekannter Art und Weise fest gelagert und nur ein Seitenbegrenzer in der vorstehend ausgeführten Art und Weise auf die Anregungsfrequenz des Schwingungserzeugers abgestimmt. In diesem Fall ist es denkbar, einen Amboss mit einer Mehrzahl von Ambossflächen vorzusehen, welche bevorzugt unterschiedliche Breiten aufweisen. Wenn der Amboss beweglich angeordnet ist, kann wahlweise eine der verschiedenen Ambossflächen zur Begrenzung von Arbeitsräumen unterschiedlicher Breite in Position gebracht werden.

Um den Arbeitsraum an eine unterschiedliche Breite anzupassen, können einer oder beide der Seitenbegrenzer auf einem gegen den Arbeitsraum hin verschiebbaren Träger montiert sein.

Gemäss einer weiteren bevorzugten Ausführungsform kann ausserdem wenigstens eines der Klemmelemente einen Anschlag für ein Werkzeug aufweisen. Dies ist insbesondere dann vorteilhaft, wenn eines oder beide der zu verbindenden Werkstücke eine Litze ist. Die Litze kann dann mit ihrem abisolierten Ende in Anschlag mit dem Klemmelement gebracht werden.

Ein weiterer Aspekt der Erfindung betrifft ein Verfahren zum Verbinden von Werkstücken. Insbesondere wird das Verfahren unter Verwendung einer wie vorstehend beschriebenen Vorrichtung durchgeführt. Dabei wird in einem ersten Schritt wenigstens ein Werkzeug in einen Arbeitsraum eingesetzt, der durch eine Arbeitsfläche einer Sonotrode, eine Ambossfläche eines Amboss und zwei Seitenbegrenzungsflächen von Seitenbegrenzern gebildet ist. Das oder die Werkstücke werden danach mit Schwingungen beaufschlagt, welche durch die Sonotrode erzeugt werden. Die Schwingungen erfolgen in einer Richtung etwa parallel zu der Arbeitsfläche der Sonotrode. Erfindungsgemäss wird die Begrenzungsfläche mindestens eines Seitenbegrenzers aufgrund des Kontaktes mit einem oder mehreren Werkstücken in Schwingungen parallel zur Arbeitsfläche versetzt. Die Frequenz dieser Schwingungen ist dabei bevorzugt derart, dass der Seitenbegrenzer nahezu in Resonanz mitschwingt.

Gemäss einer bevorzugten Ausführungsform wird wenigstens eines der Werkstücke mittels eines separaten Klemmelementes gegen den Amboss gedrückt. Dabei kann die Gegenfläche die Arbeitsfläche des Amboss sein oder eine andere Oberfläche des Amboss.

Besonders bevorzugt werden metallische Werkstücke, insbesondere Litzen und/oder Terminals, und bevorzugt aus Kupfer und/oder Aluminium miteinander verbunden. Typische Anregungsfrequenzen betragen 10 bis 40 kHz, bevorzugt 20 bis 25 kHz. Es ist aber auch denkbar, mit deutlich geringeren Frequenzen Vibrationsschweissverfahren durchzuführen. In diesem Fall müssen die Seitenbegrenzer allerdings deutlich grösser dimensioniert werden, damit sich entsprechende Eigenfrequenzen ergeben.

Die Werkstücke werden zwischen den Seitenbegrenzern im Betrieb, das heisst während des Schweissvorgangs, eingeklemmt. Dazu sind die Seitenbegrenzer insbesondere auf einem verschiebbaren Träger beweglich gelagert, so dass sie in Richtung gegen den Arbeitsraum hin mit einer Kraft beaufschlagt werden können, um die Werkstücke einzuklemmen.

Die Erfindung wird im Folgenden in Ausführungsbeispielen und anhand der Zeichnungen näher erläutert. Es zeigen:
- Figur 1:: Schematische Darstellung einer ersten Ausführungsform der Erfindung
- Figur 2:: Schematische Darstellung einer alternativen Ausführungsform der Erfindung
- Figur 3:: Schematische Darstellung einer Anordnung gemäss Figur 1 in der Draufsicht
- Figur 4:: Perspektivische Darstellung eines durch Amboss und Seitenbegrenzern definierten Arbeitsraums
- Figur 5:: Perspektivische Darstellung eines Schwingungserzeugers und einer Sonotrode
- Figur 6:: Perspektivische Darstellung einer Vorrichtung in einer Klemmposition
- Figur 7:: Vergrösserte Darstellung eines Ausschnitts aus der Vorrichtung von Figur 6 in einer geöffneten Position
- Figur 8:: Vergrösserter Ausschnitt der Vorrichtung aus Figur 6 in einer Klemmposition
- Figur 9:: Unteransicht eines Klemmelements und eines Seitenbegrenzers
- Figur 10:: Seitenansicht auf eine Begrenzungsfläche und Klemmelemente eines Seitenschiebers und
- Figur 11:: Schematische Darstellung des Schwingungsverhaltens eines Seitenbegrenzers.

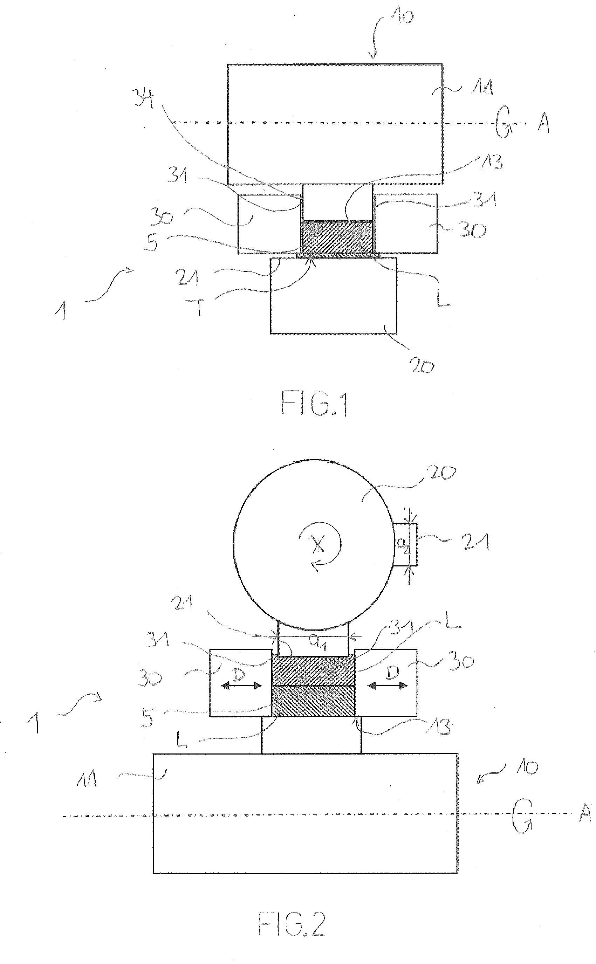

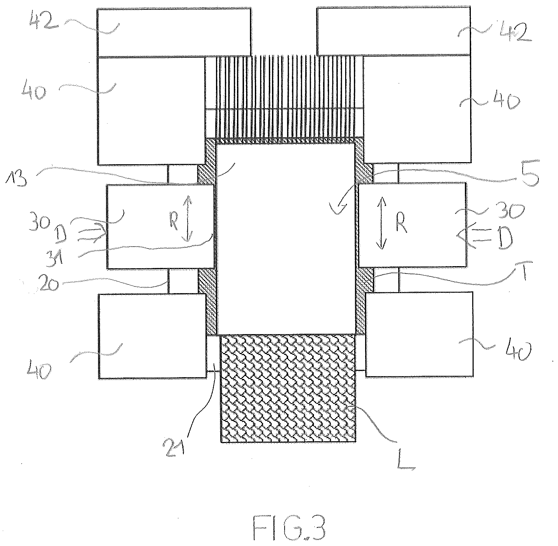

Figur 1 zeigt schematisch eine Vorrichtung 1 zum Verbinden von Werkstücken. Als Werkstücke sind schematisch eine Litze L und ein Terminal T gezeigt. Als wesentliche Komponenten weist die Vorrichtung einen Amboss 20 und eine Sonotrode 10 mit einem Sonotrodenkopf 11 auf. Die Vorrichtung weist ausserdem zwei Seitenbegrenzer 30 auf. Eine Ambossfläche 21 des Amboss 20, eine Arbeitsfläche 13 der Sonotrode 10 und Begrenzungsflächen 31 der Seitenbegrenzer 30 definieren einen Arbeitsraum 5. Zwischen den Seitenbegrenzern 30 und der Sonotrode 10 besteht ein kleiner Entkopplungsspalt 34 mit einer Breite von typischerweise 50 bis 200 µm. Damit wird verhindert, dass Schwingungen von der Sonotrode direkt in die Seitenbegrenzer eingekoppelt werden. Das Terminal T liegt auf der Ambossfläche 21 auf. Die Litze L liegt auf dem Terminal T und im Arbeitsraum 5. Durch Erzeugen von Torsionsschwingungen (das heisst Schwingungen um die Achse A des Sonotrodenkopfs 11) schwingt die Arbeitsfläche 13 in einer Richtung senkrecht zur Zeichnungsebene. Figur 1 dient der allgemeinen Erläuterung der erfindungsgemässen Vorrichtung. Die erfindungsgemässen Merkmale werden nachfolgend anhand der Figuren 3 bis 10 erläutert.

Figur 2 zeigt eine alternative Ausführungsform. In der Ausführungsform gemäss Figur 2 werden zwei Litzen L miteinander verschweisst. Der Arbeitsraum 5 wird hier durch zwei verschiebbare Seitenbegrenzer 30 definiert. Im Ausführungsbeispiel gemäss Figur 2 liegt die Sonotrode 10 mit dem Sonotrodenkopf 11 in der Figur unten, so dass die untere Litze L auf der Arbeitsfläche 13 des Sonotrodenkopfs 11 aufliegt. Die zweite Litze L liegt auf der ersten Litze L auf. Mittels eines Ambosses 20 mit einer Ambossfläche 21 werden die Litzen L im Arbeitsraum 5 komprimiert. Falls Litzen mit anderen Querschnitten verschweisst werden sollen, werden die Seitenbegrenzer verschoben und der Amboss 20 in Pfeilrichtung X gedreht und es kann eine Ambossfläche 21 mit anderer Breite a2 eingesetzt werden. In Figur 2 ist schematisch der Seitenbegrenzer 30 auf beiden Seiten identisch dargestellt. Mittels Pfeilen ist die Verstellbarkeit der Seitenbegrenzer in einer Richtung D gegen den Arbeitsraum 5 hin angedeutet. Selbstverständlich kann auch einer der Seitenbegrenzer 30 im Sinne einer an sich bekannten Ambossplatte fix ausgebildet und nur der andere Seitenbegrenzer verschiebbar sein.

Gemeinsam ist den Ausführungsbeispielen gemäss Figur 1 und Figur 2, dass die Seitenbegrenzer 30 mittels einer nicht näher dargestellten Antriebsvorrichtung gegen den Arbeitsraum 5 hin bewegbar sind. Auf diese Weise lassen sich die Werkstücke einklemmen. So wird eine schwingungsmässige Ankopplung zwischen Werkstück und Begrenzungsfläche 31 erzielt. Typische Antriebe für die Seitenbegrenzer sind Pneumatikantriebe, Hydraulik- oder Mikrohydraulikantriebe oder elektrische Antriebe.

Figur 3 zeigt schematisch eine Draufsicht auf die Ausführungsform von Figur 1. Die Litze L weist einen isolierten Abschnitt (in Figur 3 unten) und abisolierte Einzeldrähte (in Figur 3 oben) auf. Das Terminal T liegt auf der Ambossfläche 21 des Amboss 20 und unterhalb der Litze L und der Sonotrodenarbeitsfläche (in Figur 3 nur schematisch als Fläche dargestellt) im Arbeitsraum 5. Zusätzlich zu den Seitenbegrenzern 30 ist in Figur 3 beidseits des Arbeitsraums 5 ein Klemmelement 40 gezeigt. Das Klemmelement 40 klemmt das Terminal T gegen die Ambossfläche 21. In Figur 3 oben weist das Klemmelement 40 einen Anschlag 42 auf. Der Anschlag 42 definiert die Position der Litze in Litzenlängsrichtung innerhalb des Arbeitsraums 5.

Die nur schematisch dargestellten Seitenbegrenzer 30 werden mittels einer nicht im Detail dargestellten Bewegungsvorrichtung in der Richtung des Doppelpfeils D gepresst, so dass die Litzen L zwischen den Begrenzungsflächen 31 der Seitenbegrenzer 30 im Arbeitsraum geklemmt werden.

Typische Klemmkräfte, mit welchen die Seitenbegrenzer 30 in Richtung D gegen die Litzen L drücken, betragen 300 bis 3000 N.

Typische Klemmkräfte, mit denen das Terminal T gegen die Ambossfläche 21 geklemmt wird, betragen 500 N bis 5000 N. Die Breite des Arbeitsraums 5 (d.h. die Breite zwischen den Seitenbegrenzern 30) beträgt typischerweise 3 bis 35 mm, je nach Querschnitt der zu verschweissenden Litzen.

Der Pfeil R deutet an, dass die Seitenbegrenzer 30 aufgrund des Kontaktes mit der Litze L in Schwingungen versetzt werden, wenn die Litze L durch die Sonotrodenfläche 13 mit Schwingungen beaufschlagt wird.

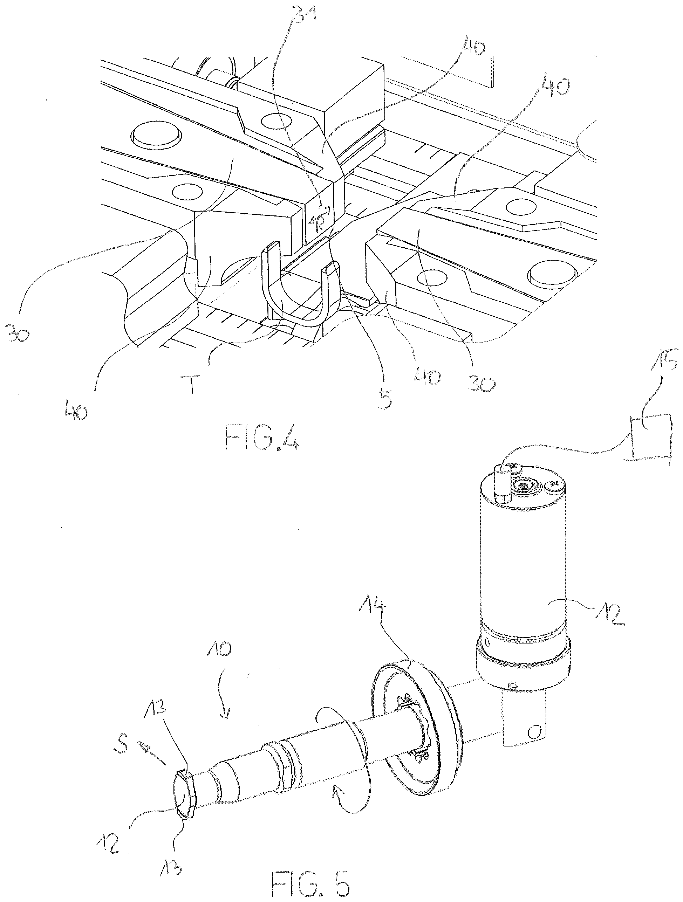

Figur 4 zeigt eine detaillierte Darstellung einer konkreten Ausführungsform. Zur Vereinfachung der Darstellung ist hier die Sonotrode weggelassen (siehe dazu Figur 5). Gemäss Figur 4 sind beidseits des Arbeitsraums 5 Seitenbegrenzer 30 angeordnet. Die Seitenbegrenzer 30 sind symmetrisch ausgebildet. Im Folgenden wird nur einer der Seitenbegrenzer 30 beschrieben. Der Seitenbegrenzer 30 weist die gegen den Arbeitsraum 5 hingerichtete Begrenzungsfläche 31 auf. In den Arbeitsraum 5 ist ein Terminal T eingesetzt. Die auf das Terminal T aufgesetzte Litze ist in Figur 4 zur Vereinfachung der Darstellung nicht gezeigt. Das Klemmelement 40 erstreckt sich auf beiden Seiten des Seitenbegrenzers 30.

Figur 5 zeigt schematisch eine Sonotrode 10. Die Sonotrode 10 wird in an sich bekannter Art und Weise mit einem Konverter 12 zu torsionalen Schwingungen (in Pfeilrichtung) angeregt. Die Sonotrode 10 ist in ebenfalls bekannter Art und Weise mit einem Entkopplungsring 14 gelagert. Die Sonotrode 10 weist einen Sonotrodenkopf 12 auf. An der Peripherie des Sonotrodenkopfs 12 sind die Arbeitsflächen 13 angeordnet (im Beispiel gemäss Figur 5 eine untere und eine obere Arbeitsfläche 13, so dass bei Verschleiss die Sonotrode 10 gedreht werden könnte). Durch Betrieb des Konverters 12 wird die Arbeitsfläche 13 in einer Schwingungsrichtung S in Schwingungen versetzt. Die Schwingungen erfolgen tangential, das heisst nicht genau in einer Ebene. Vorliegend wird unter Schweissrichtung S die Richtung der Arbeitsfläche 13 im Stillstand verstanden. Die Sonotrode 10 gemäss Figur 5 wird in der Anordnung gemäss Figur 4 so eingesetzt, dass die Schwingungsrichtung S der Richtung R entspricht, in welcher die Seitenbegrenzer 30 schwingen können. Der Konverter 12 wird in an sich bekannter Art und Weise von einem Generator 15 zu Ultraschallschwingungen mit einer Frequenz von typischerweise 20 kHz angeregt.

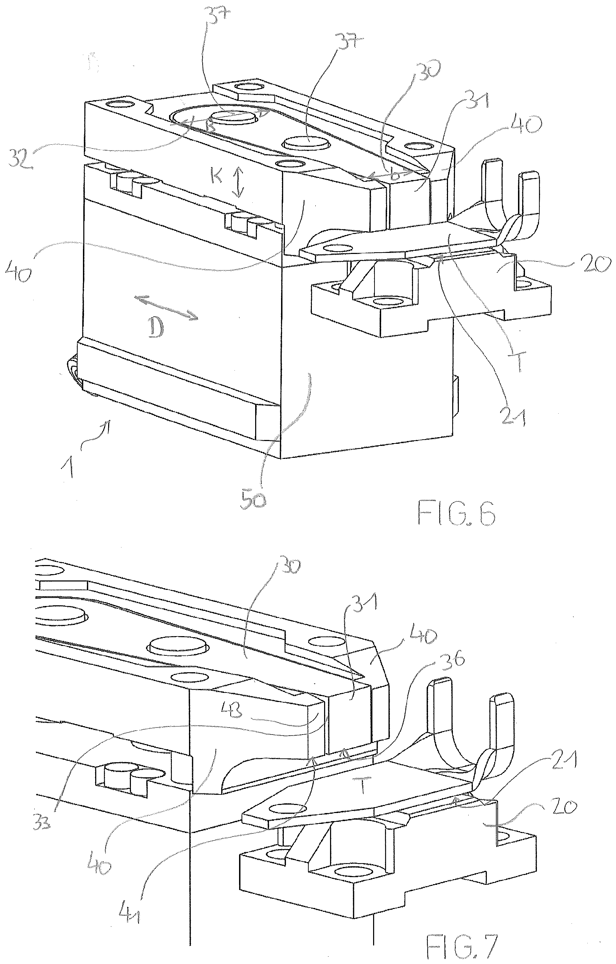

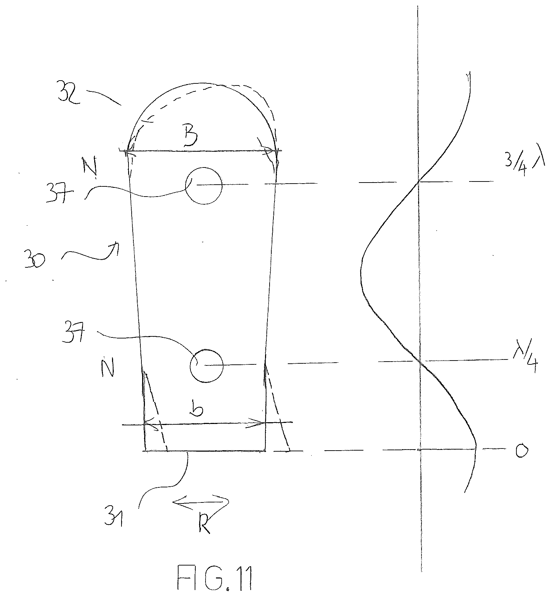

Figur 6 zeigt einen grösseren Ausschnitt aus der erfindungsgemässen Vorrichtung 1. In Figur 6 ist das Terminal T auf der Ambossfläche 21 des Ambosses 20 geklemmt. Die Klemmung erfolgt durch Bewegen des Klemmelements 40 in Pfeilrichtung K nach unten. In Figur 6 ebenfalls ersichtlich ist die konkrete Ausgestaltung des Seitenbegrenzers 30 in einer bevorzugten Ausführungsform. Der Seitenbegrenzer 30 ist mit zwei Schrauben 37 an Schwingungsknoten (siehe dazu auch Figur 11) schwingungsentkoppelt befestigt. Der Seitenbegrenzer 30 weist an seinem gegen den Arbeitsraum 5 hingerichteten Ende (das heisst der Begrenzungsfläche 31) eine Breite b auf, die geringer ist als die Breite B am abgewandten Ende. Dadurch weist der Seitenbegrenzer 30 an seinem abgewandten Ende eine höhere Masse auf. Der Seitenbegrenzer ist mit den Schrauben 37 auf einem in Richtung D verschiebbaren Schlitten 50 montiert.

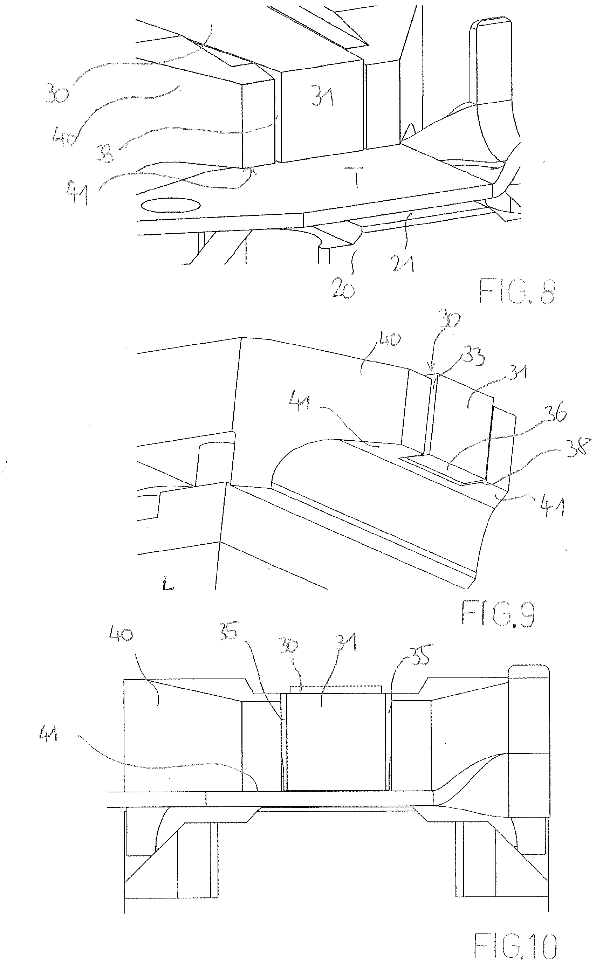

Figur 7 zeigt einen vergrösserten Ausschnitt der Vorrichtung 1 aus Figur 6, wobei sich die Klemmelemente 40 in einer geöffneten und nicht in einer Klemmposition befinden. Das Terminal T liegt dadurch noch ohne Klemmung auf der Ambossfläche 21 auf. In Figur 7 ist ersichtlich, dass die Unterseite 41 des Klemmelements 40 leicht über die Unterseite 36 des Seitenbegrenzers 30 vorsteht (siehe im Detail auch in Figur 9). Dadurch wird bei der Festklemmung des Terminals T am Amboss 20 ein Kontakt zwischen dem Seitenbegrenzer 30 und dem Terminal T verhindert. In Figur 7 ist ebenfalls dargestellt, dass zwischen dem Seitenbegrenzer 30 und dem Klemmelement 40 ein kleiner Versatz 33 vorgesehen ist. Damit wird sichergestellt, dass nur ein Kontakt zwischen der Begrenzungsfläche 31 und der Litze L (in Figur 7 nicht dargestellt) erzeugt wird und dass die Stirnfläche 43 des Klemmelements 40 nicht in Kontakt mit der Litze L gerät.

Figur 8 zeigt einen vergrösserten Ausschnitt aus Figur 6, bei dem das Terminal T mit der Unterseite 41 des Klemmelements 40 am Amboss 20 festgeklemmt ist.

Figur 9 zeigt eine Unteransicht auf den Seitenbegrenzer 30 und das Klemmelement 40. Das Klemmelement 40 umfasst den Seitenbegrenzer 30 auf der Unterseite, so dass beidseitig des Seitenbegrenzers 30 Klemmflächen 41 gebildet sind. Die dem Amboss 20 zugewandte Unterseite 36 des Seitenbegrenzers 30 ist bezogen auf die Klemmfläche 41 um einen Abstand 38 zurückversetzt, so dass kein Kontakt zwischen dem Terminal T und dem Seitenbegrenzer 30 entsteht.

Figur 10 zeigt eine Draufsicht auf die Begrenzungsfläche 31 des Seitenbegrenzers 30. In Figur 10 ist ein Spalt 35 mit einer Breite von typischerweise 50 bis 200 µm zwischen dem Seitenbegrenzer 30 und dem Klemmelement 40 ersichtlich. Auf diese Weise werden Schwingungskopplungen von dem Seitenbegrenzer 30 auf das Klemmelement 40 vermieden.

Figur 11 zeigt schematisch das Schwingungsverhalten des Seitenbegrenzers 30. Der Seitenbegrenzer 30 ist so dimensioniert und gelagert, dass er an der Begrenzungsfläche 31 ein Schwingungsmaximum aufweist, wenn er mit einer Schwingung mit einer Frequenz entsprechend der Anregungsfrequenz der Sonotrode 10 in Schwingung versetzt wird. Um eine Distanz λ/4 und λ3/4 beabstandet von der Begrenzungsfläche 31 befinden sich zwei Schwingungsknoten N, an denen der Seitenbegrenzer 30 in vorher beschriebener Art und Weise mittels Schrauben 37 schwingungsentkoppelt befestigt ist. Das von der Begrenzungsfläche 31 abgewandte Ende 32 ist verdickt ausgebildet und weist eine Breite B auf, die grösser ist als die Breite b im Bereich der Seitenbegrenzungsfläche 31.

Die beschriebenen Komponenten, insbesondere Seitenbegrenzer, Sonotrode und Amboss sind in an sich bekannter Art und Weise aus metallischen Werkstoffen, insbesondere Stahl oder Titan ausgebildet. Denkbar sind aber auch Komponenten aus Verbundwerkstoffen wie CFK oder aus Keramik.

In der in Figur 11 dargestellten Konfiguration schwingt der Seitenbegrenzer 30 in einen Biegeschwingmodus in Pfeilrichtung R. Die Biegeschwingung ist stark überhöht anhand von gestrichelten Linien an den Enden des Seitenbegrenzers 30 dargestellt.

## Patentansprüche

1. Vorrichtung (1) zum Verbinden von Werkstücken (T, L) mittels Schwingungen, insbesondere Ultraschallschwingungen, umfassend
- eine Sonotrode (10) mit einem Sonotrodenkopf (11), welche von wenigstens einem Schwingungserzeuger (12) in Schwingungen in einer Schwingungsrichtung (S) versetzbar ist und welche eine Arbeitsfläche (13) aufweist, die im Wesentlichen parallel zur Schwingungsrichtung (S) verläuft,
- einen Amboss (20), welcher eine zur Arbeitsfläche (13) gerichtete und von dieser beabstandete Ambossfläche (21) aufweist, so dass zwischen der Ambossfläche (21) und der Arbeitsfläche (13) ein Arbeitsraum (5) gebildet wird, und
- zwei Seitenbegrenzer (30) mit seitlichen Begrenzungsflächen (31), welche sich zwischen der Ambossfläche (21) und der Arbeitsfläche (13) erstrecken und welche den Arbeitsraum (15) seitlich begrenzen, **dadurch gekennzeichnet, dass** wenigstens einer der Seitenbegrenzer (30) derart geformt, dimensioniert und gelagert ist, dass die Begrenzungsfläche (31) durch Kontakt mit wenigstens einem der in den Arbeitsraum (5) eingesetzten und von der Arbeitsfläche (13) mit Schwingungen beaufschlagten Werkstücke (T, L) in Schwingungen in einer Richtung (R) etwa parallel zur Arbeitsfläche (13) versetzbar ist.

2. Vorrichtung nach Anspruch 1, wobei der wenigstens eine Seitenbegrenzer (30) derart auf die Anregungsfrequenz des Schwingungserzeugers (12) abgestimmt ist, dass der Seitenbegrenzer (30) in einem Schwingungsmodus mit einer Resonanzfrequenz schwingt, die benachbart zur und oberhalb der Anregungsfrequenz des Schwingungserzeugers (12) liegt.

3. Vorrichtung nach Anspruch 2, wobei der Schwingungsmodus ein Biegeschwingungsmodus ist.

4. Vorrichtung nach einem der Ansprüche 1 bis 3, wobei der Seitenbegrenzer (30) in wenigstens einem Schwingungsknoten (K) befestigt ist.

5. Vorrichtung nach einem der Ansprüche 1 bis 4, wobei der Seitenbegrenzer (30) auf einer der Begrenzungsfläche (31) gegenüberliegenden Seite mit einer Ausgleichsmasse (32) versehen ist und insbesondere in einer Richtung parallel zur Arbeitsfläche (13) der Sonotrode (10) gesehen eine Breite (B) aufweist, die grösser ist als die Breite (b) der Begrenzungsfläche (31).

6. Vorrichtung nach einem der Ansprüche 1 bis 5, wobei die Vorrichtung mit wenigstens einem Klemmelement (40) versehen ist, mit welchem wenigstens eines der Werkstücke (L) in einer Richtung (K) gegen den Amboss (20) klemmbar ist, wobei das Klemmelement (40) vom Seitenbegrenzer (30) schwingungsmässig entkoppelt und bevorzugt bezogen auf den Arbeitsraum (5) um einen Abstand (33) zurückversetzt ist.

7. Vorrichtung nach einem der Ansprüche 1 bis 6, wobei zwischen der Arbeitsfläche (13) der Sonotrode (10) und/oder dem Klemmelement (40) einerseits und dem Seitenbegrenzer (30) andererseits ein Spalt (34, 35) gebildet ist, wenn der Arbeitsraum (5) geschlossen ist.

8. Vorrichtung nach einem der Ansprüche 6 oder 7, wobei das Klemmelement (40) eine Klemmfläche (41) aufweist, die näher zur Ambossfläche (21) angeordnet ist als eine dem Amboss (20) zugewandte Unterseite (36) des Seitenbegrenzers (30).

9. Vorrichtung nach einem der Ansprüche 1 bis 8, wobei beide Seiten der Seitenbegrenzer (30) im Wesentlichen symmetrisch bezogen auf eine Mittenebene durch den Arbeitsraum (5) ausgebildet sind.

10. Vorrichtung nach einem der Ansprüche 1 bis 8, wobei der Amboss (20) eine Mehrzahl von Arbeitsflächen (21) aufweist, welche bevorzugt unterschiedliche Breiten (a1, a2) aufweisen und wobei der Amboss (20) beweglich angeordnet ist, so dass wahlweise unterschiedliche Ambossflächen (21) zur Begrenzung von Arbeitsräumen (5) unterschiedlicher Breite in Position bringbar sind, und wobei bevorzugt ein Seitenbegrenzer als feste Ambossplatte ausgebildet ist und der andere Seitenbegrenzer (30) in Schwingungen versetzbar ist.

11. Vorrichtung nach einem der Ansprüche 1 bis 10, wobei der wenigstens eine Seitenbegrenzer (30) auf einem verschiebbaren Träger befestigt ist, wobei der Träger insbesondere mit einem Betätigungsmittel in Richtung (D) gegen den Arbeitsraum (5) hin verschiebbar ist, so dass wenigstens eines der Werkstücke (L, T) zwischen den Seitenbegrenzern (30) festklemmbar ist.

12. Vorrichtung nach einem der Ansprüche 6 bis 11, wobei wenigstens eines der Klemmelemente (40) mit einem Anschlag (42) für wenigstens eines der Werkstücke (L) versehen ist.

13. Verfahren zum Verbinden von Werkstücken (L, T) insbesondere mit einer Vorrichtung (1) nach einem der Ansprüche 1 bis 12, mit den Schritten
- Einsetzen wenigstens eines Werkstücks (L, T), in einen durch eine Arbeitsfläche (13) einer Sonotrode (10), einer Ambossfläche (21) eines Ambosses (20) und zwei Seitenbegrenzungsflächen (31) von Seitenbegrenzern (30) definierten Arbeitsraum (5),
- Beaufschlagen wenigstens eines der Werkstücke (L, T) mit durch die Sonotrode (10) erzeugten Schwingungen mit einer Schwingungsrichtung (S) etwa parallel zur Arbeitsfläche (13),
- **dadurch gekennzeichnet, dass** mindestens eine der Begrenzungsflächen (31) eines Seitenbegrenzers (30) durch Kontakt mit wenigstens einem der in den Arbeitsraum eingesetzten und von der Arbeitsfläche (13) mit Schwingungen beaufschlagten Werkstücke (T,L) in Schwingungen in einer Schwingungsrichtung (R) parallel zur Arbeitsfläche (13) versetzt wird.

14. Verfahren nach Anspruch 13, wobei wenigstens eines der Werkstücke (L, T) mittels eines separaten Klemmelements (40) in Richtung (K) gegen den Amboss (20) gedrückt wird.

15. Verfahren nach einem der Ansprüche 13 oder 14, wobei die Werkstücke (L, T) metallische Werkstücke sind, insbesondere Litzen (L) und/oder Terminals (T), und insbesondere aus Kupfer oder Aluminium bestehen.

16. Verfahren nach einem der Ansprüche 13 bis 15, wobei die Anregungsfrequenz der Sonotrode (10) 10 bis 40 kHz, bevorzugt 20 bis 25 kHz beträgt.

17. Verfahren nach einem der Ansprüche 13 bis 16, wobei wenigstens eines der Werkstücke (L, T) zwischen den Seitenbegrenzern (30) eingeklemmt wird, insbesondere mit einer Klemmkraft in Richtung (D) gegen den Arbeitsraum (5) im Bereich von 300 N bis 3000 N.

## Claims

1. Device (1) for connecting workpieces (T, L) by means of vibrations, in particular ultrasonic vibrations, comprising:
- a sonotrode (10) having a sonotrode head (11) which by way of at least one vibration generator (12) can be excited to vibration in a vibration direction (S) and which has an operating face (13) which is substantially parallel to the vibration direction (S);
- an anvil (20) which has an anvil face (21) which is directed towards the operating face (13) and is spaced apart from the latter such that an operating space (5) is formed between the anvil face (21) and the operating face (13); and
- two lateral delimiters (30) having lateral delimiting faces (31) which extend between the anvil face (21) and the operating face (13) and which laterally delimit the operating space (15),
**characterized in that** at least one of the lateral delimiters (30) is shaped, dimensioned, and mounted in such a manner that the delimiting face (31) can, on account of contact with at least one of the workpieces (T, L) inserted into the operating space (5) and subjected to vibrations by the operating face (13), be excited to vibration in a direction (R) approximately parallel to the operating face (13).

2. Device according to Claim 1, wherein the at least one lateral delimiter (30) is tuned to the excitation frequency of the vibration generator (12) in such a manner that the lateral delimiter (30) in a vibration mode vibrates at a resonance frequency which is proximate to and above the excitation frequency of the vibration generator (12).

3. Device according to Claim 2, wherein the vibration mode is a bending vibration mode.

4. Device according to one of Claims 1 to 3, wherein the lateral delimiter (30) is fastened in at least one vibration node (K).

5. Device according to one of Claims 1 to 4, wherein the lateral delimiter (30) on a side opposite the delimiting face (31) is provided with a compensation mass (32) and, in particular when viewed in a direction parallel to the operating face (13) of the sonotrode (10), has a width (B) which is larger than the width (b) of the delimiting face (31).

6. Device according to one of Claims 1 to 5, wherein the device is provided with at least one clamping element (40) by way of which at least one of the workpieces (L) can be clamped in a direction (K) against the anvil (20), wherein the clamping element (40) in terms of vibrations is decoupled from the lateral delimiter (30) and preferably, in terms of the operating space (5), is offset backwardly by a spacing (33).

7. Device according to one of Claims 1 to 6, wherein a gap (34, 35) is formed between the operating face (13) of the sonotrode (10) and/or the clamping element (40), on the one hand, and the lateral delimiter (30), on the other hand, when the operating space (5) is closed.

8. Device according to either of Claims 6 and 7, wherein the clamping element (40) has a clamping face (41) which is disposed so as to be closer to the anvil face (21) than a lower side (36) of the lateral delimiter (30) that faces the anvil (20).

9. Device according to one of Claims 1 to 8, wherein both sides of the lateral delimiters (30) are configured so as to be substantially symmetrical with respect to a central plane through the operating space (5).

10. Device according to one of Claims 1 to 8, wherein the anvil (20) has a plurality of operating faces (21) which preferably have dissimilar widths (a1, a2), and wherein the anvil (20) is disposed so as to be movable such that different anvil faces (21) for delimiting operating spaces (5) of dissimilar widths can be selectively moved into position, and wherein one lateral delimiter is preferably configured as a fixed anvil plate and the other lateral delimiter (30) can be excited to vibration.

11. Device according to one of Claims 1 to 10, wherein the at least one lateral delimiter (30) is fastened on a displaceable support, wherein the support, in particular by way of an activation means, is displaceable in the direction (D) towards the operating space (5) such that at least one of the workpieces (L, T) can befixedly clamped between the lateral delimiters (30).

12. Device according to one of Claims 6 to 11, wherein at least one of the clamping elements (40) is provided with a stop (42) for at least one of the workpieces (L).

13. Method for connecting workpieces (L, T), in particular by a device (1) according to one of Claims 1 to 12, said method comprising the following steps:
- inserting at least one workpiece (L, T) into an operating space (5) which is defined by an operating face (13) of a sonotrode (10), an anvil face (21) of an anvil (20), and two lateral delimiting faces (31) of lateral delimiters (30);
- impinging at least one of the workpieces (L, T) with vibrations generated by the sonotrode (10), said vibrations having a vibration direction (S) which is approximately parallel to the operating face (13),
**characterized in that**
at least one of the delimiting faces (31) of a lateral delimiter (30) can, on account of contact with at least one of the workpieces (T, L) inserted into the operating space and subjected to vibrations by the operating face (13), be excited to vibration in a vibration direction (R) parallel to the operating face (13).

14. Method according to Claim 13, wherein at least one of the workpieces (L, T), by means of a separate clamping element (40), is pushed in the direction (K) against the anvil (20).

15. Method according to either of Claims 13 and 14, wherein the workpieces (L, T) are metallic workpieces, in particular strands (L) and/or terminals (T), and are in particular composed of copper or aluminium.

16. Method according to one of Claims 13 to 15, wherein the excitation frequency of the sonotrode (10) is 10 to 40 kHz, preferably 20 to 25 kHz.

17. Method according to one of Claims 13 to 16, wherein at least one of the workpieces (L, T) is clamped between the lateral delimiters (30), in particular by way of a clamping force in the range from 300 N to 3000 N in the direction (D) towards the operating space (5).

## Revendications

1. Dispositif (1) pour assembler des pièces à façonner (T, L) au moyen d'oscillations, notamment des oscillations ultrasoniques, comprenant
- une sonotrode (10) ayant une tête de sonotrode (11), laquelle peut être mise en oscillation dans une direction d'oscillation (S) par au moins un générateur d'oscillations (12) et laquelle possède une surface de travail (13) qui suit un tracé sensiblement parallèle à la direction d'oscillation (S),
- une enclume (20), laquelle est orientée vers la surface de travail (13) et possède une surface d'enclume (21) espacée de celle-ci, de sorte qu'un espace de travail (5) est formé entre la surface d'enclume (21) et la surface de travail (13), et
- deux limiteurs latéraux (30) ayant des surfaces de délimitation latérales (31), lesquelles s'étendent entre la surface d'enclume (21) et la surface de travail (13) et lesquelles délimitent latéralement l'espace de travail (15),
**caractérisé en ce qu'**au moins l'un des limiteurs latéraux (30) est façonné, dimensionné et supporté de telle sorte que la surface de délimitation (31) peut être mise en oscillation dans une direction (R) approximativement parallèle à la surface de travail (13) par contact avec au moins l'une des pièces à façonner (T, L) introduites dans l'espace de travail (5) et soumise à des oscillations par la surface de travail (13).

2. Dispositif selon la revendication 1, l'au moins un limiteur latéral (30) étant accordé à la fréquence de résonance du générateur d'oscillations (12) de telle sorte que le limiteur latéral (30), dans un mode d'oscillation, oscille à une fréquence de résonance qui est voisine de et supérieure à la fréquence d'excitation du générateur d'oscillations (12).

3. Dispositif selon la revendication 2, le mode d'oscillation étant un mode d'oscillation de flexion.

4. Dispositif selon l'une des revendications 1 à 3, le limiteur latéral (30) étant fixé dans au moins un nœud d'oscillation (K).

5. Dispositif selon l'une des revendications 1 à 4, le limiteur latéral (30) étant pourvu d'une masse de compensation (32) sur un côté opposé à la surface de délimitation (31) et possédant, notamment dans une direction vue parallèlement à la surface de travail (13) de la sonotrode (10), une largeur (B) qui est supérieure à la largeur (b) de la surface de délimitation (31).

6. Dispositif selon l'une des revendications 1 à 5, le dispositif étant pourvu d'au moins un élément de serrage (40) avec lequel au moins l'une des pièces (L) peut être serrée dans une direction (K) contre l'enclume (20), l'élément de serrage (40) étant découplé du point de vue oscillatoire du limiteur latéral (30) et étant de préférence en retrait d'un écart (33) par rapport à l'espace de travail (5).

7. Dispositif selon l'une des revendications 1 à 6, un interstice (34, 35) étant formé entre la surface de travail (13) de la sonotrode (10) et/ou l'élément de serrage (40) d'une part et le limiteur latéral (30) d'autre part lorsque l'espace de travail (5) est fermé.

8. Dispositif selon l'une des revendications 6 et 7, l'élément de serrage (40) possédant une surface de serrage (41) qui est disposée plus proche de la surface d'enclume (21) qu'un côté inférieur (36) du limiteur latéral (30) qui fait face à l'enclume (20).

9. Dispositif selon l'une des revendications 1 à 8, les deux côtés du limiteur latéral (30) étant de configuration sensiblement asymétrique en référence à un plan central à travers l'espace de travail (5).

10. Dispositif selon l'une des revendications 1 à 8, l'enclume (20) possédant une pluralité de surfaces de travail (21), lesquelles présentent de préférence des largeurs (a1, a2) différentes et l'enclume (20) étant montée mobile, de sorte que des surfaces d'enclume (21) différentes peuvent être amenées sélectivement en position en vue de délimiter des espaces de travail (5) de différentes largeurs, et un limiteur latéral étant de préférence réalisé sous la forme d'un plateau d'enclume fixe et l'autre limiteur latéral (30) pouvant être mis en oscillation.

11. Dispositif selon l'une des revendications 1 à 10, l'au moins un limiteur latéral (30) étant fixé sur un élément porteur coulissant, l'élément porteur pouvant notamment être coulissé avec un moyen d'actionnement dans une direction (D) vers l'espace de travail (5), de sorte qu'au moins l'une des pièces à façonner (L, T) peut être fermement serrée entre les limiteurs latéraux (30).

12. Dispositif selon l'une des revendications 6 à 11, au moins l'un des éléments de serrage (40) étant pourvu d'une butée (42) pour au moins l'une des pièces à façonner (L).

13. Procédé pour assembler des pièces à façonner (L, T), notamment avec un dispositif (1) selon l'une des revendications 1 à 12, comprenant les étapes suivantes :
- introduction d'au moins une pièce à façonner (L, T) dans un espace de travail (5) défini par une surface de travail (13) d'une sonotrode (10), une surface d'enclume (21) d'une enclume (20) et deux surfaces de délimitation latérales (31) de limiteurs latéraux (30),
- soumission d'au moins l'une des pièces à façonner (L, T) à des oscillations générées par la sonotrode (10) ayant une direction d'oscillation (S) approximativement parallèle à la surface de travail (13),
**caractérisé en ce que**
au moins l'une des surfaces de délimitation (31) d'un limiteur latéral (30) est mise en oscillation dans une direction (R) parallèle à la surface de travail (13) par contact avec au moins l'une des pièces à façonner (T, L) introduites dans l'espace de travail et soumises à des oscillations par la surface de travail (13).

14. Procédé selon la revendication 13, au moins l'une des pièces à façonner (L, T) étant poussée dans la direction (K) contre l'enclume (20) au moyen d'un élément de serrage (40) séparé.

15. Procédé selon l'une des revendications 13 et 14, les pièces à façonner (L, T) étant des pièces à façonner métalliques, notamment des torons (L) et/ou des bornes (T), et se composant notamment de cuivre ou d'aluminium.

16. Procédé selon l'une des revendications 13 à 15, la fréquence d'excitation de la sonotrode (10) étant de 10 à 40 kHz, de préférence de 20 à 25 kHz.

17. Procédé selon l'une des revendications 13 à 16, au moins l'une des pièces à façonner (L, T) étant serrée entre les limiteurs latéraux (30), notamment avec une force de serrage dans la direction (D) vers l'espace de travail (5) dans la plage de 300 N à 3000 N.
